# EUROPEAN PATENT SPECIFICATION

(11) **EP 4 573 228 B1**
(45) Date of publication and mention of the grant of the patent: **24.06.2026**
(21) Application number: 23741450.3
(22) Date of filing: 26.05.2023
(51) Int. Cl.: C23C 14/22, C23C 14/50, C23C 16/44, C23C 16/458, C23C 16/442

(54) **SUPPORT STRUCTURE OF PIECES TO BE COVERED, IN PARTICULAR BY MEANS OF A PVD (PHYSICAL VAPOR DEPOSITION), DLC (DIAMOND LIKE CARBON), CVD (CHEMICAL VAPOR DEPOSITION), PA-CVD (PLASMA ASSISTED CHEMICAL VAPOR DEPOSITION) OR PE-CVD (PLASMA ENHANCED CHEMICAL VAPOR DEPOSITION) COVERING**
TRAGSTRUKTUR VON BEKLEIDETEN TEILEN, INSBESONDERE MITTELS PVD (PHYSICAL VAPOR DEPOSITION) DLC (DIAMANT LIKE CARBON), CVD (PLASMA-CVD) ODER PE-CVD
STRUCTURE DE SUPPORT DE PIÈCES À REVÊTIR, EN PARTICULIER AU MOYEN D'UN REVÊTEMENT PVD (DÉPÔT PHYSIQUE EN PHASE VAPEUR), DLC (CARBONE DE TYPE DIAMANT), CVD (DÉPÔT CHIMIQUE EN PHASE VAPEUR), PA-CVD (DÉPÔT CHIMIQUE EN PHASE VAPEUR ASSISTÉ PAR PLASMA) OU PE-CVD (DÉPÔT CHIMIQUE EN PHASE VAPEUR ACTIVÉ PAR PLASMA)

(43) Date of publication of application: 25.06.2025
(73) Proprietor: Argor-Aljba SA, 6850 Mendrisio (CH)
(72) Inventor: ZAGO, Mirko, 6900 Paradiso (CH)
(74) Representative: M. Zardi & Co S.A.
(86) International application number: PCT/IB2023/055419
(87) International publication number: WO 2024/246577

(56) References cited:
- EP-B1- 1 299 570
- US-A- 5 470 388
- US-A1- 2004 142 230
- US-A1- 2015 140 211
- US-B1- 6 197 120

## Description

### Field of application

The present invention relates to a support structure for a plurality of parts to be superficially coated with at least one layer of solid material deposited by means of a coating process such as PVD (Physical Vapor Deposition), DLC (Diamond Like Carbon), CVD (Chemical Vapor Deposition), PA-CVD (Plasma Assisted Chemical Vapor Deposition) or PE-CVD (Plasma Enhanced Physical Vapor Deposition) coating.

The present invention also relates to an apparatus for carrying out the aforementioned process, provided with a chamber in which the support structure for the plurality of parts to be superficially coated with at least one layer of solid material is installed.

Furthermore, the present invention relates to a method for operating the support structure of the aforementioned type, in order to expose efficiently the surfaces of the parts to be coated by means of the processes of the aforementioned type (e.g. PDV or DLC).

### Prior art

It is known that in surface coating processes such as PVD (Physical Vapor Deposition) or DLC (Diamond Like Carbon), to mention just a few, the parts to be coated, for example special small metal parts, are first mounted on a carousel, below also referred to as a support structure since it has the purpose of supporting the parts, keeping them suspended in a vacuum chamber, so that their surface is well exposed to the flow of coating material.

The parts to be coated may be the precision bits of a tool, gearing, springs, to mention only a few examples which are not limiting in any way, since essentially the parts may be any metal component with a size such that they may be arranged in the vacuum chamber in order to be coated.

The type of coating may have various chemical compositions such as compositions consisting of nitrides, carbonitrides or amorphous carbon (DLC - Diamond Like Carbon). These examples relating to the chemical compositions of the coating type are not limiting and other stoichiometric compositions may be used. Furthermore, the coating may be performed on a single layer (single-layer coating) or on a plurality of superimposed layers (multi-layer coating) and, if carried out on several layers, each layer may consist of a composition which is identical to that of another layer or have a different composition, in which case the multi-layer coating is also referred to as a "hybrid coating".

The coating is required in order to improve the characteristics of the part, for example in order to increase the corrosion resistance, scratch resistance and resistance to chemical agents or in order to provide the part with biocompatibility properties, in order to increase the surface hardness or the wear resistance, in order to reduce the friction with other parts during use in a machine, but also for aesthetic reasons (to mention just a few uses thereof).

The quality of the coating is carefully tested and the parts which do not satisfy predetermined physical requisites are discarded, with a loss of efficiency of the production apparatus, or, should the parts be used, with an inferior performance.

Therefore, for correct execution of the coating process, it is important that the support structure should be configured to expose all the surfaces of the part to be coated to the reactive species contained in the plasma or in the reactive process gases. These vary depending on the type of coating required. The coating must have a uniform thickness and color.

This object is normally achieved by using a support structure which comprises a plurality of gripping (or engaging) points, one for each part to be coated, and a movement mechanism which involves both a rotation about an axis Y of the gripping point (and therefore a rotation about the axis Y of the part supported by it) and a rotation of the entire support structure about an axis X of the structure, which may be parallel or perpendicular to the axis Y of the gripping point. Therefore, n rotations of the part about the axis Y may be performed during a single rotation (revolution) of the structure about the axis X, with a planetary-type movement.

The movement of the part is continuous over time about both axes.

The part is not movable with respect to the gripping point, but fixed thereto.

This movement has proved to be effective and easily controlled, since it is possible to adjust the speed of rotation about the axes X, Y.

However, drawbacks are also known to exist.

Firstly, the fixing of the part to the gripping point is performed manually and is therefore costly from an economic point of view.

The above is applicable in particular to small-size parts with a relatively low economic value, since manual operation has a greater impact on the overall cost of the coating.

In fact, the time required to mount some parts may be so long that the treatment is not feasible from a practical point of view. This is the case, for example, of small metal parts with very small dimensions. In this connection, recently it has been found that there exists the need to coat components for the clothing sector, such as the teeth, the sliders or the pullers of a zip fastener. Each tooth must be separately treated, before being assembled in a zip fastener, but fixing thereof to a gripping point is unacceptable from a cost point of view. Furthermore, in the zone where the tooth is fixed to the structure it is not possible to deposit the coating.

Other drawbacks relate to the realization of a gripping point which does not interfere with the surface to be coated, something which is not at all obvious given the size of the parts (such as the aforementioned teeth) and the need to fix them manually.

Furthermore, the time needed to unload the parts from the support structure is not negligeable and has an impact on the overall cost.

The problem underlying the present invention is to device a support structure for parts to be treated with a surface coating process, of the PVD (Physical Vapor Deposition), DLC (Diamond Like Carbon), CVD (Chemical Vapor Deposition), PA-CVD (Plasma Assisted Chemical Vapor Deposition) or PE-CVD (Plasma Enhanced Chemical Vapor Deposition) type, which is able to reduce drastically the loading and unloading times, especially for small-size parts, and which is also able to avoid damaging interference with the surfaces to be coated and ensure a quality of the coating which is not inferior to that achieved with the known support structures, substantially overcoming the limitations which hitherto affect the known support structures and coating processes.

US 5 470 388, US2004/ 142230 and US 6197 120 are examples of support structures.

### Summary of the invention

A support structure for a plurality of parts to be superficially coated with at least one layer of solid material deposited by means of a coating process such as PVD according to present invention is claimed in claim 1.

Preferred embodiments of the support structure according to the present invention are given in dependent claims 2 to 7.

The support structure is a structure for parts to be coated using a process such as PVD (Physical Vapor Deposition), DLC (Diamond Like Carbon), CVD (Chemical Vapor Deposition), PA-CVD (Plasma Assisted Chemical Vapor Deposition) or PE-CVD (Plasma Enhanced Chemical Vapor Deposition), where the support structure is designed to avoid fixing of the parts.

The parts to be coated are deposited, in the support structure, without keeping them suspended in the empty space, but allowing them to come into contact with each other and/or with a support surface.

The parts are left free to move on the support surface, without gripping points which control the predetermined displacement thereof.

The idea in particular is that of allowing the loading *en bloc* of a plurality of parts onto the structure, without processing (handling) the parts individually.

This loading operation, also referred to as "bulk loading", is immediate and may be performed by pouring the parts *en masse* from an initial container onto the loading segment of the support structure which comprises the support surface.

Tens, hundreds or also thousands of parts may be loaded in a very short period of time (of the order of seconds or minutes).

The plurality of parts bulk loaded onto the loading segment assumes a random position on the support surface.

The parts are moved by means of the movement of the loading segment, for example a circular movement about the axis X of the structure, as in the carousels of the prior art.

The movement is performed at a constant angular speed. During this movement, each part maintains its own spatial orientation, which is the orientation assumed following bulk loading.

In principle, therefore, this movement does not cause a variation in the position of the parts with respect to the support surface.

The support surface may, in fact, be flat.

In order to ensure that the coating material is not prevented from flowing towards a surface portion of the parts, i.e. the portion directed towards (or in contact with) the support surface or towards (or in contact with) one or more adjacent parts, the orientation of the parts on the support surface is varied at predefined intervals.

The variation in the orientation of the parts on the support surface may be random or non-random.

The coating process is carried out for a sufficiently long period of time so that the whole of the surface of each part is exposed for a sufficiently long time to the flow of coating material (i.e. plasma) in order to ensure the coating efficiency.

The variation in the orientation may be performed in a step-like manner.

In particular, a predetermined surface portion A1i of each part i may be exposed for a time period T, leaving instead a remaining surface portion B1i not exposed, because it is contact with the support surface or with other parts. Then, for example with a stepwise movement, the orientation of a few (at least some) of the parts i is varied, so that a new surface portion A2i of the parts i (at least some of them) may be exposed for a time period T, leaving instead a remaining surface portion B2i not exposed, because it is in contact with the support surface or other parts.

The surface portion A1i of one part i may be different from the surface portion A1i+1 of a part i+1.

In one embodiment, the exposed surface portions A1i, A2i of a part i before and after the change in orientation may have a common surface portion A'.

The change in orientation does not necessarily involve the selection of predetermined surface portions to be exposed which are different from each other.

In the event of a random change in the exposure of the surface portion A1i, A2i of a part i the duration of the treatment may be determined statistically.

Advantageously, the pre-setting of a predetermined period T of exposure of the surface portion A1i is able to ensure sufficient continuity of the coating and suitable coverage of the surface portion A1i.

The change in the exposure surface A1i→A2i is performed, for example, by a profile interfering with the parts i. For example, the profile is a rack situated at a predetermined point on the loading segment and designed to come into contact with the parts i arriving at the predetermined point, owing to the rotation of the support structure about the axis X and in relation to the rack.

Obviously, it is also possible for the rack to rotate with respect to the loading segment.

Furthermore, depending on the geometry of the loading segment, the movement of the rack (i.e. of the interference profile) may vary.

Advantageously, as already mentioned, the parts i which are situated on the loading segment, but far from the point (area) in which the rack is operative do not undergo a variation in the exposure surface and receive the coating material continuously on the exposed surface portion until their subsequent interaction with the interference profile (used here as a synonym for rack).

Advantageously, the variation of the exposed surface portion is not determined by a displacement along predetermined axes X, Y, but may occur in multiple (potentially an infinite number of) directions.

The interference between the profile and the parts i may be direct and/or indirect.

"Indirect interference" of a part i is understood as meaning the case where the part i may change its exposure surface as a result of interference of the profile with one or more other parts i-1, i+1 with which the profile comes into contact or also with other parts i+2 which in turn are subject to indirect interference by the part i+1.

Preferably, the rack also has the effect of spreading out the plurality of parts i which are bulk loaded onto the loading segment, for example loaded in a heap.

A heap of parts i with a maximum height H may then be flattened by the rack to a height h corresponding to the height of the rack with respect to the loading segment, i.e. the support surface, which may be adjustable. Depending on the height of the rack, two or more parts i, i+1 may be arranged on top of each other on the loading segment, until a following interaction with the rack. The rack may be configured to spread out the parts i, i+1 uniformly over the loading segment, avoiding positioning on top of one another.

As mentioned, the terms "rack" or "interference profiles" have been used here above as synonyms, which moreover are not limiting. Basically it is possible to use any means suitable for:
- allowing partial exposure of the surfaces of the parts on the loading segment in order perform coating, leaving the parts free on the loading segment and
- changing the exposure of the surfaces of the parts during coating; and
- repeating the change in exposure so that each point P on the surface of each part is exposed, overall, sufficiently.

The coating must have a homogeneous and uniform color and thickness. The Applicant has noticed that, although the parts are reoriented during the coating process in an entirely random manner, repetition of the re-orientation together with a sufficiently long exposure is able to ensure that the results are fully achieved, also in terms of homogeneity and uniformity of color and thickness.

For example, the profile may be a curved blade which has a first end on the support surface and a second end at a predetermined height therefrom. The parts are transported towards the blade, loaded at the first end thereof, move upwards towards the second end and are unloaded from it, with a rolling movement which results in random re-orientation thereof.

The indirect interference may be achieved also or as a result of the interaction of the interference profile with the loading segment.

This occurs for example in the case of a hammer profile which strikes a loading segment which acts as a drum and on top of which the parts are shaken by means of the blows of the profile, being turned over with respect to a previous position (i.e. assuming a new orientation).

The interaction between the interference profile and the parts may also be determined on the basis of the shape and size of the parts.

Even though hitherto the term "profile" has been used, another means may be used in order to change the orientation of the parts. Examples of embodiment thereof will be provided in the description below. Advantageously, the loading segment may be repeated, preferably towards the top of the structure, forming a plurality of loading segments associated with respective interference profiles, thus multiplying the aforementioned effects and the yield of the coating process.

The support structure comprises a plurality of parts to be superficially coated with at least one layer of solid material deposited by means of a coating process such as PVD (Physical Vapor Deposition), DLC (Diamond Like Carbon), CVD (Chemical Vapor Deposition), PA-CVD (Plasma Assisted Chemical Vapor Deposition) or PE-CVD (Plasma Enhanced Physical Vapor Deposition) coating, and comprises:
- at least one loading segment designed to receive the plurality of parts to be coated, leaving each part free to acquire its own orientation within a three-dimensional space of the at least one loading segment, following bulk loading of the plurality of parts onto the at least one loading segment;
- at least one means operatively associated with the at least one loading segment, configured to change the orientation within the three-dimensional space of at least some of the plurality of parts on the loading segment.

The means is a pneumatic, mechanical or ultrasound hammer which acts on the loading segment. The change in orientation is achieved by means of the transmission of the striking force on the at least one loading segment to at least some of the plurality of parts on the loading segment, each part being free to acquire its own orientation within the three-dimensional space of the at least one loading segment, as a result of the striking force, this orientation being different from that freely assumed before the striking force.

The term "three-dimensional space of the at least one loading segment" is understood as meaning the useful loading space defined inside the loading segment, but also the space which is situated outside the loading segment and within which a part may move during re-orientation, even though then returning into the loading space. For example, the loading space may be a tank with a flat bottom and circular wall which defines a space inside the tank; the parts, when changing their orientation and being reoriented, may come out of the space inside the tank, bouncing outside of it, vertically, and then falling back by means of gravity inside it.

The means is operated with a predetermined frequency.

The means is also operated for a predetermined duration.

According to the invention, the means is a profile movable with respect to at least one loading segment and is configured to interfere with at least some of the plurality of parts to be coated which, during use, are situated on the loading segment in the proximity of the profile.

The at least one profile is configured to interfere with at least some of the plurality of parts to be coated which, during use, are located in the proximity of the profile and to change the orientation of at least some of the plurality of parts.

The change in orientation corresponds to a variation in the surface of the part which is exposed to the coating.

According to the invention, the support structure is configured to rotate about an axis X with respect to a fixed chamber inside which the coating process is carried out.

The at least one profile is configured not to interfere with at least a remaining portion of the plurality of parts to be coated which, during use, are situated on the loading segment, but not in the proximity of the profile.

The movement of the plurality of parts is caused by a vibration which is induced in the structure. The vibration is induced at regular time intervals. The vibration is induced, for example, by means of one or more sonotrodes or a hammer.

In one embodiment, the change in orientation of at least some of the plurality of parts is random.

The change in orientation of at least some of the plurality of parts is predetermined with each contact between the at least one profile and at least some of the plurality of parts to be coated.

The contact may be direct or indirect.

The at least one profile is configured to remain fixed with respect to the chamber.

The at least one loading segment comprises a loading surface. Preferably, the loading surface comprises a plurality of through-holes with a size smaller than that of each of the parts to be supported.

The at least one loading segment rotates about the axis X and the axis X is perpendicular to the loading surface of the loading segment.

However, all the parts are free to change their orientation in any direction.

According to the invention, the at least one profile is configured to move with respect to the chamber of the apparatus in order to perform the coating (i.e. PVD, DLC, etc.).

In one embodiment the loading segment is circular.

A plurality of loading segments may be superimposed along the axis X. At least one profile is provided for each of the plurality of loading segments.

The aforementioned technical problem is also solved by an apparatus for carrying out a process for coating a plurality of parts to be superficially coated with at least one layer of solid deposited material, for example a PVD (Physical Vapor Deposition), DLC (Diamond Like Carbon), CVD (Chemical Vapor Deposition), PA-CVD (Plasma Assisted Chemical Vapor Deposition) or PE-CVD (Plasma Enhanced Chemical Vapor Deposition) coating process. The apparatus is characterized in that it comprises a support structure according to Claim 1.

Finally, a method for moving a plurality of parts to be superficially coated with at least one layer of solid material deposited during a coating process comprises the following steps:
- bulk loading the plurality of parts to be coated onto at least one loading segment on which the plurality of parts is free to move, the at least one loading segment being operatively associated with at least one means designed to change the orientation on the loading segment of at least some of the plurality of parts and to allow the uniform superficial coating of the plurality of parts.

### Brief description of the attached figures

Figure 1 is a schematic view from above of the support structure according to the present invention.
Figure 2 is a schematic cross-sectional view of the support structure according to Figure 1.
Figure 3 is a schematic view of a detail of Figure 2, relating to a loading segment, during an operating step in which the parts to be coated are loaded.
Figure 4 is a schematic top plan view of a detail of Figure 2, relating to the loading segment.
Figure 5 is a schematic view of a loading segment according to a variation of embodiment of the present invention.
Figure 6 is a schematic cross-sectional view of a support structure according to a variant of the present invention.
Figure 7 is a schematic view of a detail of Figure 4, relating to a plurality of loading segments.
Figure 8 shows a support structure according to an embodiment.
Figure 9 is a plan view of the structure according to Figure 8.
Figure 10 shows the support structure 1 inside a vacuum chamber of an apparatus for carrying out the coating process.

### Detailed description of an embodiment

With reference to the attached figures, an embodiment of the support structure 1 according to the present invention is described below.

The support structure 1 is intended to be installed inside an apparatus for carrying out a superficial coating process such as PVD (Physical Vapor Deposition), DLC (Diamond Like Carbon), CVD (Chemical Vapor Deposition), PA-CVD (Plasma Assisted Chemical Vapor Deposition) or PE-CVD (Plasma Enhanced Chemical Vapor Deposition) coating.

The parts to be coated may be - to cite just a few examples which are not limiting in any way - the precision bits of a tool, gearing, springs, screws, but also any metal component ("part) with a size such that it may be arranged inside the vacuum chamber of the apparatus.

The coating process is applied to a plurality of parts simultaneously supported inside the vacuum chamber by the support structure. Therefore, the expression "plurality of parts" is normally employed in the description below.

However, the coating process could be applied to a single part supported inside the vacuum chamber by the support structure. The expression "plurality of parts" therefore relates to the normal use and not so much to structural, mechanical or process limitations in the management of a single part, which in fact do not exist.

The support structure is movable inside the vacuum chamber, for example with a uniform circular movement. The movement, especially the circular movement, is intended to expose uniformly all the surfaces of the parts to be coated to the plasma generated inside the vacuum chamber.

The type of coating may have various chemical compositions such as compositions consisting of nitrides, carbonitrides or amorphous carbon (DLC - Diamond Like Carbon). These examples relating to the chemical compositions of the coating type are not limiting. Other stoichiometric compositions may be used. Furthermore, the coating may be performed on a single layer (single-layer coating) or on several superimposed layers (multi-layer coating). If it is realized on a plurality of superimposed layers, each layer may consist of a composition identical to that of another layer, or having a different composition, in which case (layers with a different composition) the multi-layer coating is also referred to as a hybrid coating.

The coating is required in order to improve the characteristics of the part, for example in order to increase the corrosion resistance, scratch resistance and resistance to chemical agents or in order to provide the part with biocompatibility properties, in order to increase the surface hardness or the wear resistance, and in order to reduce the friction with other parts during use in a machine, but also for aesthetic reasons (to mention just a few uses thereof).

In the description below a specific example of embodiment of the invention is provided, although it is not limiting, with regard to the form or the mechanism of the support structure 1.

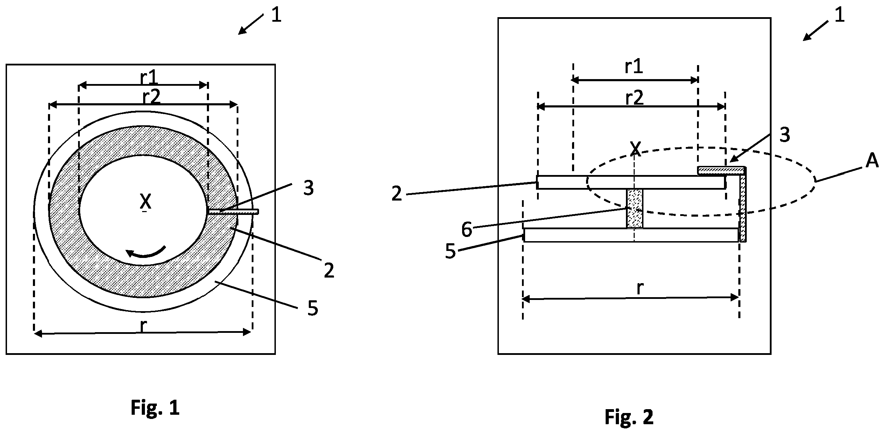

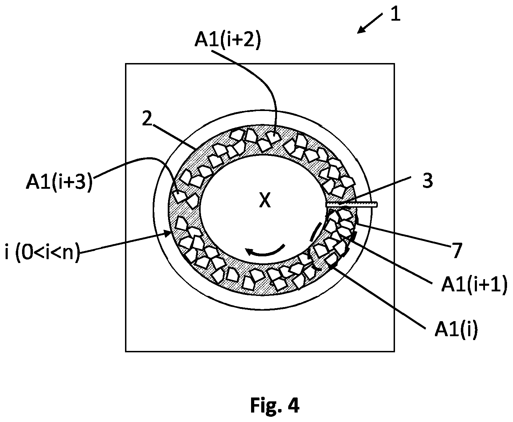

In Figures 1 and 2 the support structure 1 has a circular form and is provided with a base 5 which operatively supports a rod 6 rotating about an axis X perpendicular to the base 5. A section of the rod 6 is associated with a segment 2 for loading a plurality of parts to be coated which are denoted overall by i (0<i<n) in Figure 4.

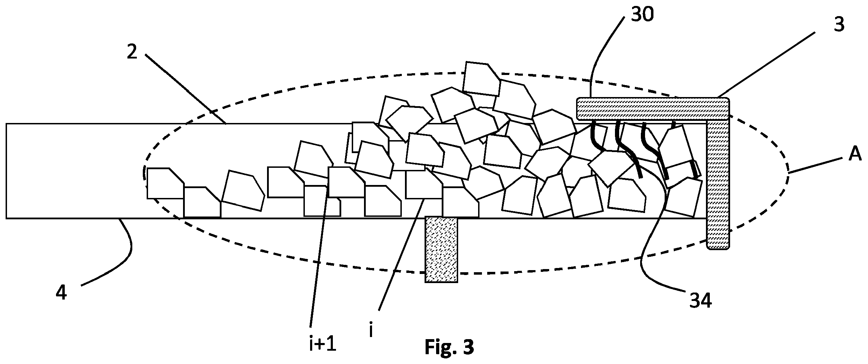

The parts i are bulk loaded onto the loading segment 2, as schematically shown in Figure 3. The parts have for example the same three-dimensional form, but are oriented randomly in space on the loading segment 2.

A support surface 4 of the loading segment 2 (Fig, 3) is in direct contact with some parts i, but depending on the quantity of loaded parts i, the parts i may be (partially) superimposed so as to be only partially in contact with the support surface 4 or not in contact with it all. A part i may have any orientation in the space.

The support surface 4 is meshed, with holes having a diameter smaller than the size of the parts i, so that the parts do not fall through the holes. The plasma may also reach the surface of the parts i directed towards the support surface 4 owing to the presence of the holes, at least the surfaces which are not in contact with the structure of the mesh. In one embodiment, the support surface 4 does not have a meshed structure; for example, the support surface 4 may be continuous. In order to ensure a correct coating, both in the case where the support surface 4 is meshed and in the case where the support surface 4 is not meshed, the process parameters may be adjusted.

The support surface 4 is preferably planar.

A plan-view cross-section of the support surface 4 is, for example, circular. The support surface 4 is for example a circular tank with an outer diameter and an inner diameter. The circular tank has an outer edge and an inner edge, namely an outer side surface and an inner side surface, extending perpendicularly from the support surface 4, in order to contain the parts. Both the support surface 4, and the outer and inner side surfaces are meshed, i.e. provided with holes having a size smaller than the parts to be coated, so as to allow the plasma to flow through the holes, towards the parts.

Once they have been loaded onto the loading segment 2, the parts i are substantially unmovable with respect to the said loading segment 2, apart from possible settling movements due to the unstable equilibrium following loading. As mentioned, the parts are moved with a circular movement (Fig. 1) of the loading segment 2 about the axis X for a predefined time period. Such a movement is performed in order to allow, during execution of the process, uniform coating of the surface portion of the parts i which is exposed to the surface treatment (i.e. exposed to the plasma) during the predefined time period. In fact, considering that the plasma or process gas flow in a first section of the vacuum chamber may differ from the flow in a second section, it is preferable that the surface portion should be exposed to the treatment both in the first section and in the second section of the chamber which the part passes along with a circular movement.

Figure 4 shows in schematic form the surface portion A1(i) of a part i, the surface portion A1(i+1) of a part (i+1), the surface portion A1(i+2) of a part (i+2) and the surface portion A1(i+3) of a part (i+3) at the time T1. The parts i, i+1 are also shown in Figure 3. The surface portions A1(i), A1(i+1) A1(i+2), A1(i+3) remain exposed for the predefined time period (T), while the surface portions B1(i), B1(i+1), B1(i+2), B1(i+3) - not shown in the figure - remain inaccessible because they are in direct contact with the support surface or with other parts i+5, ...

According to the present invention, so that these surfaces B1(i), B1(i+1), B1(i+2), B1(i+3), also along following sections, are exposed to the treatment, it is envisaged changing the orientation of the parts i, i+1, i+2, i+3 with respect to the loading segment 2. The change in orientation does not affect *en bloc* all of the parts i, i+1, i+2, i+3 present on the loading segment 2, at least not necessarily. For example, Figure 4 shows a subgroup 7 of the parts, which comprises the parts i and i+1, but not the parts i+2 and i+3. As a result, the surface B1(i), B1(i+1) of the parts i and i+1 is at least partially subjected to the change of orientation, and thus exposed to the coating treatment, while the surface B1(i+2), B1(i+3) of the parts i+2 and i+3 is not subjected to the change of orientation, thus leaving the surface A1(i+2), A1(i+3) of the parts i+2, i+3 always exposed to the treatment.

The change in orientation may be performed via a means 3.

In Figure 2 the means is a profile 3 provided with brushes 34. The profile 3 is supported above loading segment 2 by means of a rod, at a predetermined distance from the surface 4 supporting the parts i. The loading segment 2 is provided with a lateral structure 5 for containing the parts i, which also passes below the profile 3. The parts are transported underneath the profile 3 by the circular movement of the loading segment 2 and come into contact with brushes 34 which mix up the parts I and change their orientation in a random manner. The profile 3 comes into contact directly or indirectly with the subgroup of parts situated in the proximity, while the remaining parts are not affected by the profile and therefore do not change their orientation. Therefore, the frequency in the change of orientation of a part may be determined by the speed of rotation (i.e. the rotational frequency) of the loading segment 2. The parts which are not subjected to a change in orientation continue to receive the treatment (plasma or process gases) on the same exposed surfaces Ai. This continuity ensures that the plasma is sufficiently consolidated and therefore that the coating is homogeneous and uniform. Only the parts subjected to a change in orientation start to receive the treatment (plasma) on the surfaces Bi previously not exposed or at least on part of the surfaces which have not been previously exposed, which are able to take advantage of the continuous treatment for at least the time needed to complete rotation of the loading segment 2, following which they will again be subjected to the profile 3.

The profile 3 therefore has the function of changing the orientation of the parts.

In one embodiment, the profile 3 also has the function of spreading out the parts. They may be loaded onto the loading segment 2 in a heap, for example in a heap which has a height greater than the profile 3 with respect to the support surface 4. In this case, the parts situated at a height in the heap greater than the height of the profile 3, come into contact with a top part of the profile 30 (Fig. 3) and are pushed downwards (towards the support surface 4), reducing the height of the heap, namely flattening it below the profile 3. Such a configuration allows immediate bulk loading of the parts i.

According to the aspect indicated above, the change in orientation is selective since the profile 3 acts only on a subgroup of parts.

Embodiments are envisaged however where the change in orientation is widespread, i.e. affects all the parts.

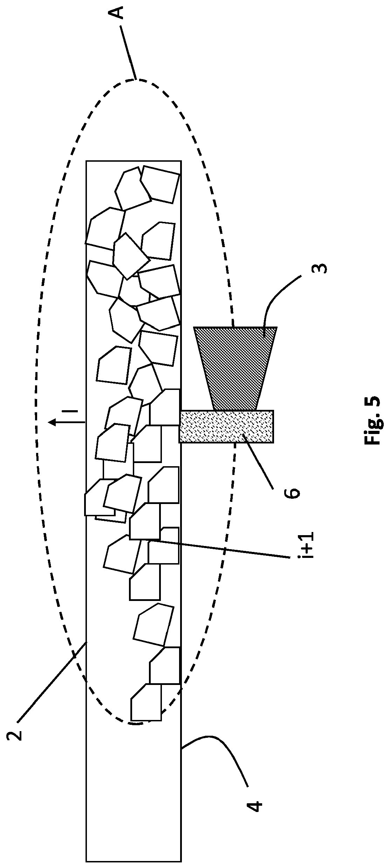

With reference to Figure 5, for example, the loading segment 2 is associated with a means 3. The means 3 may be operatively mounted on the rod 6 of the loading segment 2 or on other parts of the support structure 1. The means 3 is operated so as to impart a force onto the support structure 1 which is designed to cause a change in the direction of movement of the loading segment 2. For example, the means 3 is a mechanical, pneumatic or ultrasound hammer which imparts a blow to the rod 6 already performing a uniform circular movement, resulting in a rectilinear jolting movement 1 (as indicated by means of the upwardly directed arrow I in Fig. 5). The means 3 are configured so that the impulsive force terminates rapidly; the jolting movement, for example upwards, of the loading segment is therefore followed by an immediate return movement downwards. As a result of the impulsive force and its immediate cessation, the parts are jolted by a small amount, for example upwards, and then fall back onto the support surface 4, with a new random orientation.

The duration of the force which is applied may be adjusted, for example depending on the weight, the number, the size of the parts and/or the size of the loading segment 2 and/or a height of the lateral containing surface, and therefore also depending on the amplitude of the three-dimensional space inside which reorientation of the parts may be performed, without causing them to fall from the loading segment. The frequency of the force applied may also be adjusted.

The set frequency determines the frequency of change in orientation of a part. All the parts undergo a change in orientation the moment the force is applied. In order to ensure sufficient continuity of the treatment and therefore allow sufficient consolidation of the plasma, the frequency is suitably set.

Furthermore, although the example given relates to an upwards impulsive force, depending on the geometry of the support structure and/or process parameters, a force may be applied in one or more other directions.

The idea described above, i.e. of realizing the sudden change in direction of the normally circular movement of the loading segment 2 in order to obtain a reorientation of the parts, may also be realized by other means 3. For example, a retractable projection of the support structure may be operated so as to interfere or not interfere with the loading segment 2 and, respectively, cause a change in direction thereof or not have any effect on it.

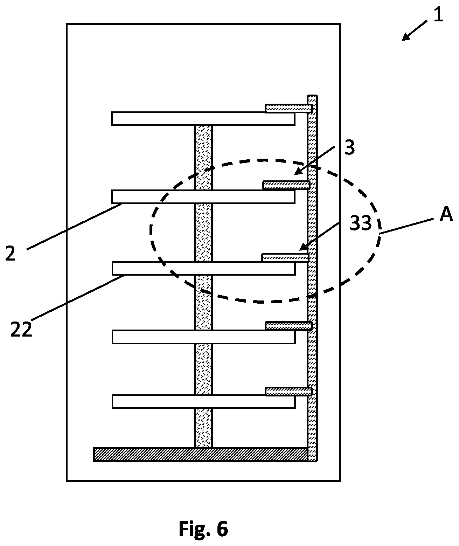

The yield of the coating process, understood as being the number of parts correctly coated in a predefined treatment time, is significantly increased thanks to the support structure provided, especially in the case of small-size parts. The yield is further increased in the variations of embodiment in which the support structure is expanded or replicated, for example as shown in Figure 6. Several loading segments 2, 22 are arranged along a rotating rod. Several profiles 3, 33, one for each segment 2, 22, are connected to the loading segments in order to change the orientation of the parts. The support structure of this example is developed vertically and comprises interference profiles 3. According to other embodiments, not shown, the support structure may be developed in a horizontal direction or in other directions and/or other means 3 may be used in order to realize the change in orientation. For example, a single hammer means 3 may strike only one rod on which all the loading segments 2 are mounted in order to cause the simultaneous change in orientation of all the parts on the support structure 1.

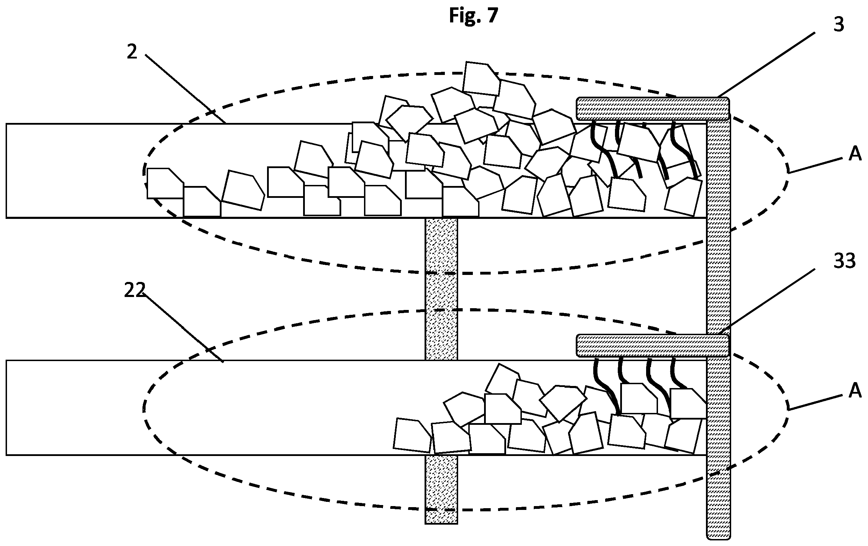

Figure 7 shows in schematic form an example of operation, in which two loading segments 2, 22 are loaded with a different number of parts. A profile 3 spreads out the parts loaded in a heap on the loading segment 2, while a profile 33 does not perform this function on the respective loading segment 22. Both the profiles 3, 33 perform the function of reorientating the parts.

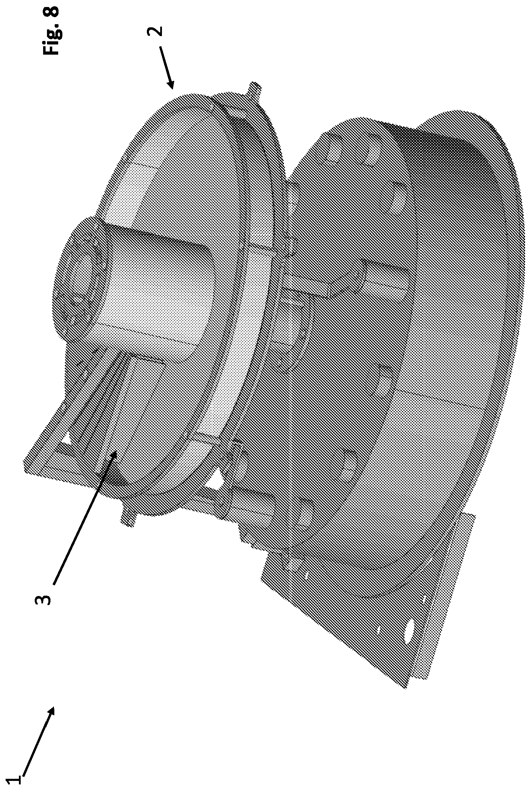

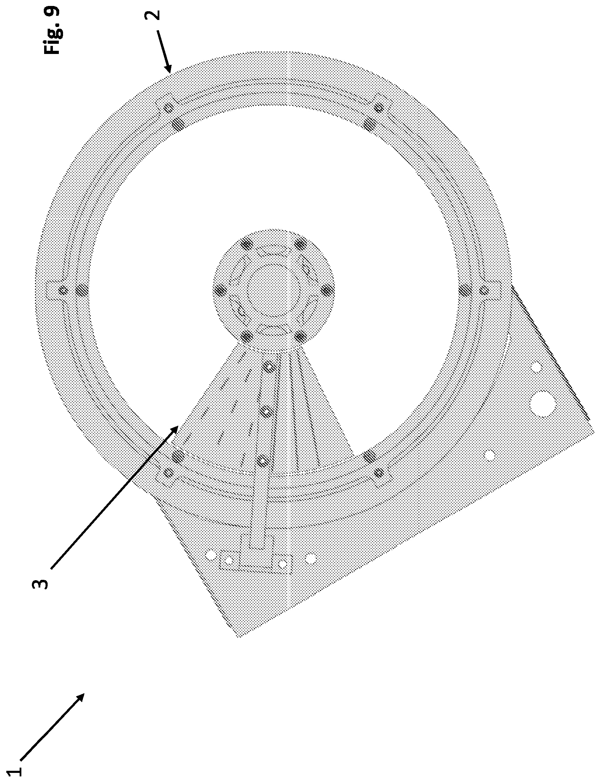

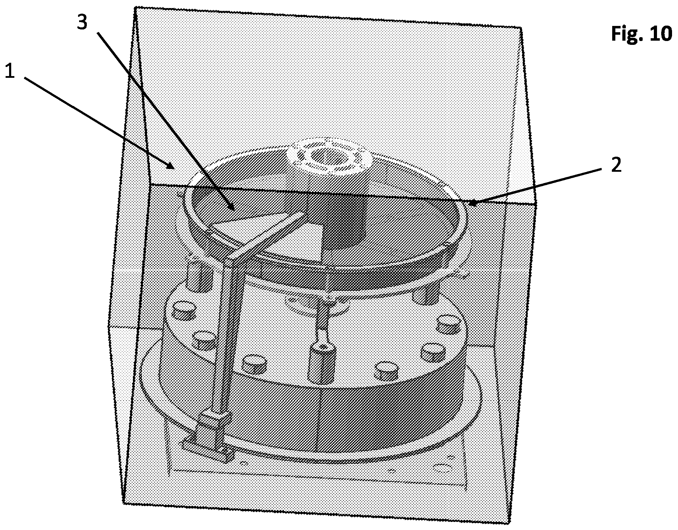

Figure 8 shows an embodiment of the support structure 1. The profile 3 is in the form of a spatula or blade, supported by a rod which extends outside the loading segment 2. Figure 9 is a top plan view of the structure according to Figure 8. Figure 10 shows in schematic form the support structure 1 installed inside a vacuum chamber of an apparatus for carrying out the coating process.

## Claims

1. Support structure (1) for a plurality of parts to be superficially coated with at least one layer of solid material deposited by means of a coating process such as PVD (Physical Vapor Deposition), DLC (Diamond Like Carbon), CVD (Chemical Vapor Deposition), PA-CVD (Plasma Assisted Chemical Vapor Deposition) or PE-CVD (Plasma Enhanced Physical Vapor Deposition) coating, comprising:
- at least one loading segment (2) designed to receive the plurality of parts to be coated, leaving each part free to acquire its own orientation within a three-dimensional space of the at least one loading segment (2), following bulk loading of the plurality of parts onto the at least one loading segment (2);
- at least one means (3) operatively associated with the at least one loading segment (2), configured to change the orientation within the three-dimensional space of at least some of the plurality of parts on the loading segment (2), wherein
the support structure (1) is configured to rotate about an axis (X),
the at least one means is a profile (3) movable with respect to the at least one loading segment (2) and is configured to interfere with some of the plurality of parts to be coated which, during use, are contacted by the profile (3), and not to interfere with a remaining part of the plurality of parts to be coated which, during use, are not contacted by the profile (3),
**characterized in that**
- the at least one loading segment (2) comprises a loading surface (4),
- the loading surface (4) is a flat surface including a plurality of through-holes and supporting the plurality of parts,
the axis (X) is perpendicular to the loading surface (4).

2. Support structure (1) according to Claim 1, **characterized in that** said change in orientation of at least some of the plurality of parts is random.

3. Support structure (1) according to Claim 1, **characterized in that** said change in orientation of at least some of the plurality of parts is predetermined with each contact between the at least one profile (3) and at least some of the plurality of parts to be coated.

4. Support structure (1) according to Claim 1, **characterized in that** the at least one profile (3) is configured to remain fixed with respect to the chamber.

5. Support structure (1) according to Claim 1, **characterized in that** the loading surface (4) comprises a plurality of through-holes with a size smaller than each of the parts to be supported.

6. Support structure (1) according to Claim 1, **characterized in that** the loading segment (3) is circular.

7. Support structure (1) according to Claim 1, **characterized in that** it comprises a plurality of loading segments (2, 22) arranged above each other along the axis (X) and at least one means (3, 33) for each segment of the plurality of loading segments.

## Patentansprüche

1. Tragstruktur (1) für eine Mehrzahl von Teilen, um oberflächlich mit mindestens einer Schicht aus festem Material beschichtet zu werden, das mittels eines Beschichtungsverfahrens wie PVD (Physical Vapor Deposition), DLC (Diamond-Like Carbon), CVD (Chemical Vapor Deposition), PA-CVD (Plasma Assisted Chemical Vapor Deposition) oder PE-CVD (Plasma Enhanced Physical Vapor Deposition) aufgebracht wird, umfassend:
- mindestens ein Ladungssegment (2), das dazu ausgelegt ist, die Mehrzahl von zu beschichtenden Teilen aufzunehmen, wobei jedes Teil nach dem massenhaften Laden der Mehrzahl von Teilen auf das mindestens eine Ladungssegment (2) frei ist, seine eigene Ausrichtung innerhalb eines dreidimensionalen Raums des mindestens einen Ladungssegments (2) einzunehmen;
- mindestens eine Einrichtung (3), die funktionsmäßig mit dem mindestens einen Ladungssegment (2) verbunden und so konfiguriert ist, dass sie die Ausrichtung innerhalb des dreidimensionalen Raums von mindestens einigen der Mehrzahl von Teilen auf dem Ladungssegment (2) verändert, wobei
die Tragstruktur (1) so konfiguriert ist, dass sie sich um eine Achse (X) dreht, die mindestens eine Einrichtung ein Profil (3) ist, das relativ zu dem mindestens einen Ladungssegment (2) beweglich ist und so konfiguriert ist, dass es mit einigen der Mehrzahl von zu beschichtenden Teilen in Eingriff kommt, die während des Gebrauchs von dem Profil (3) berührt werden, und nicht mit einem verbleibenden Teil der Mehrzahl von zu beschichtenden Teilen in Eingriff kommt, die während des Gebrauchs nicht von dem Profil (3) berührt werden, **dadurch gekennzeichnet, dass**
- das mindestens eine Ladungssegment (2) eine Ladefläche (4) umfasst,
- die Ladefläche (4) eine ebene Fläche ist, die eine Mehrzahl von Durchgangslöchern aufweist, und die Mehrzahl von Teilen trägt,
die Achse (X) senkrecht zur Ladefläche (4) steht.

2. Tragstruktur (1) nach Anspruch 1, **dadurch gekennzeichnet, dass** die Änderung der Ausrichtung zumindest einiger der Mehrzahl Teile zufällig ist.

3. Tragstruktur (1) nach Anspruch 1, **dadurch gekennzeichnet, dass** die Änderung der Ausrichtung zumindest einiger der Mehrzahl Teile bei jedem Kontakt zwischen dem mindestens einen Profil (3) und zumindest einigen der Mehrzahl zu beschichtenden Teile vorgegeben ist.

4. Tragstruktur (1) nach Anspruch 1, **dadurch gekennzeichnet, dass** das mindestens eine Profil (3) so konfiguriert ist, dass es gegenüber der Kammer feststehend bleibt.

5. Tragstruktur (1) nach Anspruch 1, **dadurch gekennzeichnet, dass** die Ladefläche (4) eine Mehrzahl Durchgangsbohrungen aufweist, deren Größe kleiner ist als die der einzelnen zu tragenden Teile.

6. Tragstruktur (1) nach Anspruch 1, **dadurch gekennzeichnet, dass** das Ladungssegment (3) kreisförmig ist.

7. Tragstruktur (1) nach Anspruch 1, **dadurch gekennzeichnet, dass** sie eine Mehrzahl von Ladungssegmenten (2, 22), die entlang der Achse (X) übereinander angeordnet sind, und mindestens eine Einrichtung (3, 33) für jedes der Mehrzahl von Ladungssegmente umfasst.

## Revendications

1. Structure de support (1) pour une pluralité de pièces destinées à être revêtues superficiellement d'au moins une couche de matériau solide déposée au moyen d'un procédé de revêtement tel qu'un revêtement PVD (dépôt physique en phase vapeur), DLC (carbone de type diamant), CVD (dépôt chimique en phase vapeur), PA-CVD (dépôt chimique en phase vapeur assisté par plasma) ou PE-CVD (dépôt physique en phase vapeur amplifié par plasma), comprenant :
- au moins un segment de chargement (2) conçu pour recevoir la pluralité de pièces à revêtir, en laissant chaque pièce libre d'acquérir sa propre orientation dans un espace tridimensionnel de l'au moins un segment de chargement (2), après chargement en vrac de la pluralité de pièces sur ledit au moins un segment de chargement (2) ;
- au moins un moyen (3) associé de manière fonctionnelle à l'au moins un segment de chargement (2), configuré pour modifier l'orientation, dans l'espace tridimensionnel, d'au moins certaines des pièces de la pluralité de pièces sur le segment de chargement (2), dans laquelle
la structure de support (1) est configurée pour tourner autour d'un axe (X),
l'au moins un moyen est un profil (3) mobile par rapport à l'au moins un segment de chargement (2) et est configuré pour interférer avec certaines des pièces de la pluralité de pièces à revêtir qui, en utilisation, sont mises en contact avec le profil (3), et pour ne pas interférer avec une partie restante de la pluralité de pièces à revêtir qui, en utilisation, ne sont pas mises en contact avec le profil (3),
**caractérisée en ce que**
- l'au moins un segment de chargement (2) comprend une surface de chargement (4),
- la surface de chargement (4) est une surface plane comportant une pluralité de trous traversants et supportant la pluralité de pièces,
l'axe (X) est perpendiculaire à la surface de chargement (4).

2. Structure de support (1) selon la revendication 1, **caractérisée en ce que** ladite modification d'orientation d'au moins certaines des pièces de la pluralité de pièces est aléatoire.

3. Structure de support (1) selon la revendication 1, **caractérisée en ce que** ladite modification d'orientation d'au moins certaines des pièces de la pluralité de pièces est prédéterminée à chaque contact entre ledit au moins un profil (3) et au moins certaines des pièces de la pluralité de pièces à revêtir.

4. Structure de support (1) selon la revendication 1, **caractérisée en ce que** l'au moins un profil (3) est configuré pour rester fixe par rapport à la chambre.

5. Structure de support (1) selon la revendication 1, **caractérisée en ce que** la surface de chargement (4) comprend une pluralité de trous traversants d'une taille inférieure à celle de chacune des pièces à supporter.

6. Structure de support (1) selon la revendication 1, **caractérisée en ce que** le segment de chargement (3) est circulaire.

7. Structure de support (1) selon la revendication 1, **caractérisée en ce qu'**elle comprend une pluralité de segments de chargement (2, 22) disposés les uns au-dessus des autres le long de l'axe (X) et au moins un moyen (3, 33) pour chaque segment de la pluralité de segments de chargement.
